**Europäisches Patentamt**

**European Patent Office**

**Office européen des brevets**

(19)

(11) Veröffentlichungsnummer : **0 524 338 B1**

(12) # EUROPÄISCHE PATENTSCHRIFT

(45) Veröffentlichungstag der Patentschrift :
**22.02.95 Patentblatt 95/08**

(51) Int. Cl.⁶ : **G05F 1/618**, G05B 19/05

(21) Anmeldenummer : **91112521.9**

(22) Anmeldetag : **25.07.91**

(54) **Eingabestufe für digitale Signale.**

(43) Veröffentlichungstag der Anmeldung :
**27.01.93 Patentblatt 93/04**

(45) Bekanntmachung des Hinweises auf die
Patenterteilung :
**22.02.95 Patentblatt 95/08**

(84) Benannte Vertragsstaaten :
**AT CH DE FR GB IT LI SE**

(56) Entgegenhaltungen :
**EP-A- 0 111 028
CH-A- 512 858
DE-A- 2 814 856
DE-A- 2 948 358
FR-A- 2 637 752**

(73) Patentinhaber : **SIEMENS
AKTIENGESELLSCHAFT
Wittelsbacherplatz 2
D-80333 München (DE)**

(72) Erfinder : **Heitzer, Herbert Dipl.-Ing. (FH)
Waldhausstrasse 24
W-8457 Kümmersbruck (DE)**
Erfinder : **Rumold, Gerhard Dipl.-Ing. (FH)
Lukasstrasse 5
W-8526 Bubenreuth (DE)**

**Beschreibung**

Die Erfindung betrifft eine Eingabestufe für digitale Signale, wie sie bei Prozeßrechenanlagen und bei speicherprogrammierbaren Steuerungen als periphere Eingabeschnittstelle verwendet wird. Solche Peripherie-Baugruppen werden bei einer Anlage in verhältnismäßig großer Anzahl benötigt und man versucht, die in diesen entstehende, in Wärme umgesetzte Verlustleistung möglichst gering zu halten, damit ein selbstbelüfteter Betrieb ohne Kühlluftzufuhr möglich wird.

Aus der DE-A1-28 14 856 ist eine Eingabestufe für digitale Signale bekannt, bei der ein Schmitt-Trigger und eine hierzu parallelgeschaltete Zweipolanordnung in einem integrierten Schaltkreis angeordnet sind. Die Zweipolanordnung der DE-A1-2814856 ist dabei als Konstantstromsenke ausgebildet.

Im Hinblick auf eine wirtschaftliche Fertigung bei großen Stückzahlen ist man bestrebt, Eingabestufen mit den Mitteln moderner Halbleitertechnologie zu implementieren, d.h., sie als integrierte Schaltkreise zu realisieren. Hierbei muß die im integrierten Schaltkreis betriebsmäßig entstehende Verlustleistung so niedrig gehalten werden, daß dieser nicht durch Wärmeentwicklung zerstört wird. Insbesondere wenn mehrere gleichartige Eingangskanäle in einem gemeinsamen Schaltkreis zusammengefaßt werden sollen, wird diese Verlustleistungsgrenze sehr schnell überschritten und ist beispielsweise bei den für speicherprogrammierbare Steuerungen bestimmten Eingabestufen infolge des aus Kompatibilitätsgründen durch internationale Normen für den "EIN"-Zustand der Eingabestufe vorgeschriebenen Mindeststroms ohne weitergehende Maßnahmen in vielen Anwendungsfällen und vor allem bei mehrkanaliger Ausführung nicht mehr einzuhalten bzw. führt zu aufwendigen und damit teueren Leistungsgehäusen für den Schaltkreis.

Aufgabe der Erfindung ist es, eine mit moderner Halbleitertechnologie billig herstellbare Eingabestufe mit geringer Verlustleistung zu schaffen. Diese Aufgabe wird erfindungsgemäß mit den im Hauptanspruch angegebenen Merkmalen gelöst. Grundgedanke der Erfindung ist es also, eine an sich schon durch die Verwendung einer Konstantstromsenke minimierte Verlustleistung zu ihrem größten Teil außerhalb des integrierten Schaltkreises entstehen zu lassen.

Die Erfindung samt ihren in den Unteransprüchen gekennzeichneten Ausbildungen soll nachstehend anhand der Figuren näher veranschaulicht werden. Es zeigen:

Figur 1      den prinzipiellen Aufbau einer erfindungsgemäßen Konstantstromsenke,

Figur 2      eine Grundform der erfindungsgemäßen Eingabestufe,

Figur 3      eine funktionell angereicherte Variante der Erfindung mit besonders kleiner Verlustleistung im Schaltkreis,

Figur 4      die Realisierung einer Zweipolanordnung mit negativer Widerstandscharakteristik,

Figur 5      die mehrkanalige Ausführung der Eingabestufe auf einem Baugruppenträger.

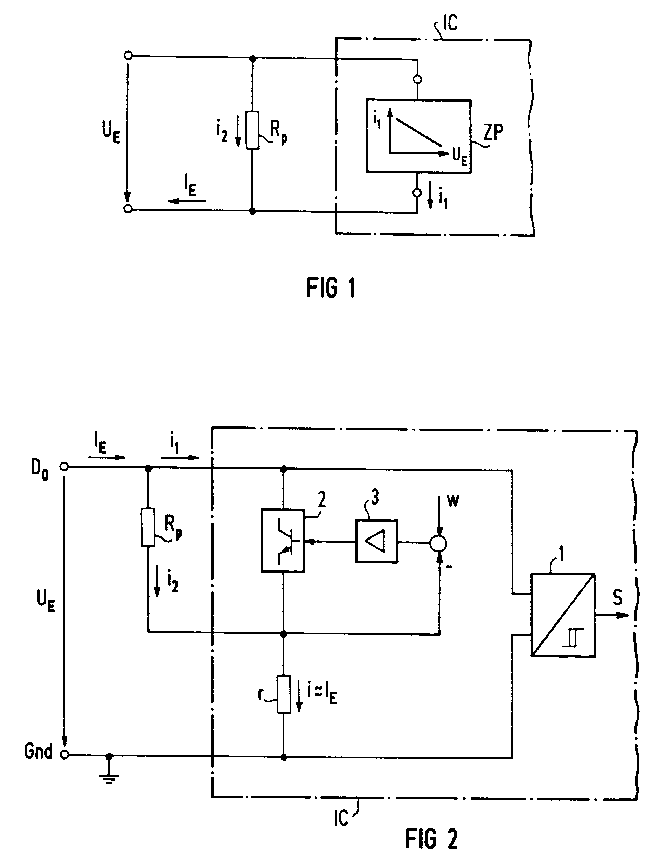

Figur 1 zeigt den prinzipiellen Aufbau einer erfindungsgemäßen Konstantstromsenke. In einem integrierten Schaltkreis IC ist eine mit ZP bezeichnete Zweipolanordnung mit negativer Widerstandscharakteristik implementiert. Eine negative Widerstandscharakteristik bedeutet, wie auch die in dem Blocksymbol des Zweipols ZP dargestellte Kennlinie wiedergibt, daß der den Zweipol durchfließende Strom $i_1$ abnimmt, wenn die am Zweipol ZP anliegende Spannung $U_E$ zunimmt. Die dargestellte Kennlinie läßt sich analytisch mit

$$i_1 = i_0 - m \cdot U_E$$

beschreiben, wobei $i_0$ und $m$ konstante, vorgebbare Größen sind. Dem Zweipol ist schaltkreisextern ein vom Strom $i_2$ durchflossener Widerstand $R_p$ zugeordnet. Für den Gesamtstrom der Stromsenke ergibt sich dann $I_E = i_2 + i_1 = i_0 + U_E(1/R_p - m)$. Der ohmsche Widerstandswert $R_p$ des schaltkreisextern parallel dem Zweipol zugeordneten Widerstandes und die Steigung $m$ der Strom-Spannungs-Charakteristik des Zweipols ZP werden nun so gewählt, daß $m = 1/R_p$ ist. Dann ergänzt der schaltkreisexterne Widerstand $R_p$ die Zweipolanordnung ZP zu einer Konstantstromsenke, d.h. der durch die in Figur 1 dargestellte Gesamtanordnung fließende Strom wird unabhängig von der jeweils anliegenden Eingangsspannung $U_E$. Denn jedem Stromanstieg des Stromes $i_2$ infolge einer Erhöhung der Eingangsspannung $U_E$ entspricht eine gleichgroße Verminderung des Stromes durch den Zweipol ZP und umgekehrt. Wesentlich ist bei dem erfindungsgemäßen Aufbau dieser Konstantstromsenke, daß dann, wenn die Eingangsspannung $U_E$ und damit die Verlustleistung insgesamt am größten ist, der den Zweipol durchfließende Strom $i_1$ am kleinsten ist und somit im integrierten Schaltkreis nur ein Bruchteil dieser Verlustleistung entsteht.

Konstantstromsenken der vorstehend beschriebenen Art lassen sich mit bekannten Zweipolen mit negativer Widerstandscharakteristik aufbauen, wie sie samt ihrer Justierung beispielsweise in der CH-PS 512 858 beschrieben sind.

Figur 2 zeigt eine einfache Möglichkeit zum Aufbau der erfindungsgemäßen Eingabestufe mit einer Konstantstromsenke gemäß Figur 1. Im integrierten Schaltkreis IC befindet sich ein von der an den Klemmen $D_0$ und Gnd (Masse) angeschlossenen Eingangsspannung $U_E$ beaufschlagter Schmitt-Trigger 1, welcher ein den "Ein"-Zustand der Eingabestufe repräsentierendes Signal S dann abgibt, wenn die Eingangsspannung $U_E$ einen bestimmten Mindestwert von überschreitet. Bei Eingabestufen für speicherprogrammierbare Steuerungen ist dieser Wert durch Normvorschriften auf 11 V festgelegt, wobei gleichzeitig auch noch vorgeschrieben ist, daß bei diesem Zustand der von der Eingabestufe aufgenommene Strom $I_E$ mindestens den Wert von 6 mA aufweist. Zweckmäßigerweise wird die aus dem Widerstand $R_p$ und der hierzu parallelgeschalteten Kollektor-Emitter-Strecke eines Transistors 2 bestehende Konstantstromsenke für diesen Mindeststromwert bemessen, d.h., daß der Widerstandswert des schaltkreisextern angeordneten Widerstandes $R_p$ wird so groß bemessen, daß er bei einem maximalen Wert der Eingangsspannung von $U_{Emax}$ von einem Strom $I_{Emin}$ durchflossen wird, der geringfügig über diesem Mindeststrom von 6 mA liegt, während bei diesem Wert der Eingangsspannung $U_E$ die in der Kollektor-Emitterstrecke des Transistors 2 bestehende Zweipolanordnung einen so großen Widerstandswert aufweist, daß sie praktisch von keinem Strom durchflossen wird. Verringert sich die Eingangsspannung von diesem maximalen Wert, dann bewirkt eine entsprechende Ansteuerung des Transistors 2 eine Verminderung des Widerstandswertes der Kollektor-Emitterstrecke. Diese Ansteuerung erfolgt durch das Ausgangssignal eines Stromreglers in Form des Verstärkers 3, dem als Sollwert eine dem genannten Mindeststromwert $I_{Emin}$ proportionale Größe und als Istwert die an einem mit dem Transistor 2 in Reihe liegenden Strommeßwiderstand r abfallende Spannung zugeführt ist. Der Widerstand r kann dabei einen recht kleinen Wert aufweisen. Besteht der Sollwert in dem konstanten Wert $w = r \cdot I_{Emin}$, dann wird der Stromregler 3 durch entsprechende Beaufschlagung der Steuerstrecke des Transistors 2 dessen Widerstand in dem Sinne solange verändern, bis die Regelabweichung annähernd den Wert Null erreicht, so daß unter Vernachlässigung der sehr kleinen Stromaufnahme des Schmitt-Triggers 1 gilt

$$r.I_{Emin} = r \cdot i \approx r \cdot I_E$$

oder

$$I_E = I_{Emin} = constant.$$

Auf diese Weise kann der Eingangsstrom $I_E$ der Eingabestufe konstant gehalten werden, wobei mit der zuvor erwähnten Dimensionierung des schaltkreisexternen Widerstandes $R_p$ bei der maximalen Eingangsspannung $U_{Emax}$ die dabei auftretende maximale Verlustleistung ausschließlich in dem Widerstand $R_p$ entsteht und bei sinkender Eingangsspannung die in dem Transistor 2 bestehende Zweipolanordnung mit negativer Widerstandscharakteristik zunehmend mehr Strom übernimmt. Der größte Wert der von dem integrierten Schaltkreis IC aufzunehmenden Verlustleistung ergibt sich dann, wenn in beiden Zweigen der aus dem Widerstand $R_p$ und dem Transistor 2 bestehenden Parallelschaltung der gleiche Strom fließt und beträgt dann ungefähr ein Viertel der maximalen Verlustleistung $U_{Emax} \cdot I_{Emin}$.

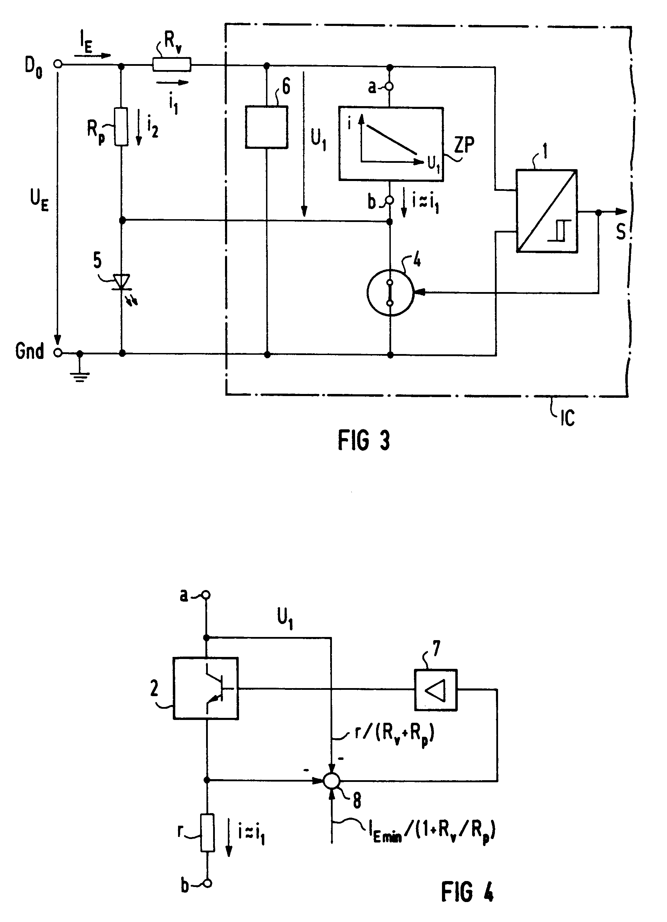

Figur 3 zeigt eine gegenüber der Anordnung nach Figur 2 funktionell angereicherte Ausführungsform der erfindungsgemäßen Eingabestufe, bei welcher die Verlustleistung im integrierten Schaltkreis nochmals reduziert ist. Sie enthält zusätzlich einen integrierten Schalter 4, welcher mit dem Ausgangssignal S des Schmitt-Triggers 1 so betätigt wird, daß er beim Erreichen des "Ein"-Zustandes geöffnet und somit einen Stromfluß durch eine zuvor von ihm kurzgeschlossene Leuchtdiode 5 bewirkt, womit der "Ein"-Zustand nach außen sichtbar gemacht werden kann. Angedeutet in dem Schaltbild der Figur 3 ist noch eine mit 6 bezeichnete Schutzbeschaltung, welche im wesentlichen aus mit Masse (Gnd) verbundenen Dioden besteht und in an sich bekannter Weise definierte Spannungspotentiale innerhalb des integrierten Schaltkreises sicherstellen soll. In dem den Zweipol ZP mit negativer Widerstandscharakteristik enthaltenden Zweig der Konstantstromsenke ist ein mit $R_v$ bezeichneter schaltkreisexterner Widerstand eingefügt, welcher einerseits als Strombegrenzungswiderstand für die Schutzschaltung 6 und den Schmitt-Trigger 1, vor allem aber der spannungsmäßigen Entlastung des Zweipols ZP dient. Bei gleicher strommäßiger Belastung wie bei der Anordnung gemäß Figur 2 wird nämlich der Zweipol ZP mit einer Spannung beaufschlagt, welche um den Spannungsabfall an dem mit ihm in Reihe geschalteten Widerstand $R_v$ vermindert ist. Damit kann gegenüber der Anordnung nach Figur 2 eine wesentliche Reduzierung der im integrierten Schaltkreis IC entstehenden Verlustleistung erreicht werden.

Bezeichnet man mit $U_1$ die am Zweipol abfallende Spannung und mit i den ihn durchfließenden Strom, dann läßt sich die Stromspannungscharakteristik des Zweipols wiederum analytisch beschreiben mit $i = i_0 - m \cdot u_1$. Es wurde aber nun erkannt, daß für $m = 1/(R_v + R_p)$ und für $i_0 = I_{Emin}/(1 + R_v/R_p)$ gewählt werden muß, damit bei veränderlicher Eingangsspannung $U_E$ der Eingangsstrom $I_E$ stets den konstanten Wert $I_{Emin}$ aufweist.

Figur 4 zeigt eine Schaltung, mit welcher die für das Konstantstromverhalten erforderliche Widerstandscharakteristik für den zwischen den Punkten a und b vorzusehenden Zweipol realisiert werden kann. Wiederum wird dieses Verhalten durch das Ausgangssignal eines Stromreglers 7 erzwungen, welcher jetzt aber nicht den Gesamtstrom der Stromsenke regelt, sondern nur den Strom in ihrem den Zweipol enthaltenden Zweig. Der Istwert dieses Zweigstromes i, welcher unter Vernachlässigung der geringen Stromaufnahmen von Schutzbeschaltung 6 und Schmitt-Trigger 1 dem Strom $i_1$ durch den Vorwiderstand $R_v$ entspricht, wird als Spannungsabfall an einem Strommeßwiderstand r abgenommen und einem Mischglied 8 zugeführt. Der Sollwert besteht in der konstanten Größe $i_0 \cdot r$ mit $i_0 = I_{Emin}(1 + R_v/R_p$. Zusätzlich wird dem Mischglied subtraktiv die mit dem

EP 0 524 338 B1

konstanten Faktor $r/(R_v + R_p)$ bewichtete Zweipolspannung $U_1$ zugeführt. Der Stromregler verstellt nun durch entsprechende Beaufschlagung der Steuerstrecke des Transistors 2 dessen Kollektor-Emitter-Widerstand solange, bis der Regelabgleich erreicht ist, d.h., bis gilt

$$r \cdot I_{Emin} /(1 + R_v/R_p) - r \cdot U_1/(R_v + R_p) - r \cdot i_1 = 0$$

oder

$$i_1 = I_{Emin}/(1 + R_v/R_p) - U_1/(R_v + R_p).$$

Der Stromregler 7 erzwingt also die für das Konstantstromverhalten der Gesamtanordnung erforderliche Widerstandscharakteristik des zwischen den Punkten a und b vorzusehenden Zweipols.

Im Interesse einer möglichst großen Spannungsentlastung des im integrierten Schaltkreis IC vorgesehenen Zweipols ZP wird man den Vorwiderstand $R_v$ möglichst groß wählen. Bewegt sich der mögliche Wertebereich beim "Ein"-Zustand der Eingabestufe zwischen der eingangs erwähnten Mindestspannung $U_{Emin}$ und der maximal zu erwartenden Spannung $U_{Emax}$, dann ergibt sich für zulässige Werte des Vorwiderstandes $R_v$ die Beziehung

$$R_v \leqq R_p/(U_{Emax}/U_{Emin} - 1).$$

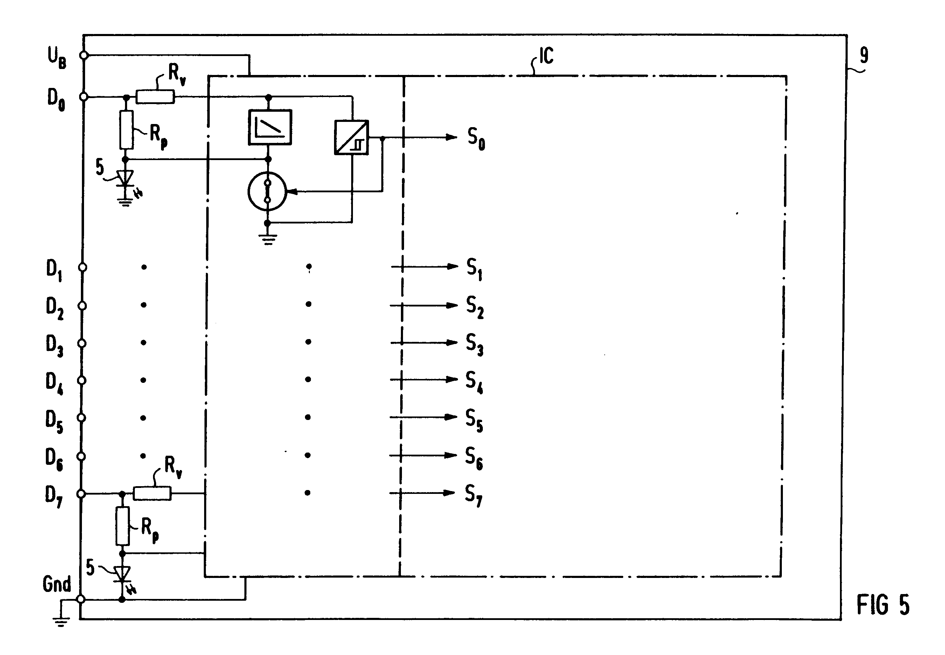

Die konsequente Verlagerung des größten Teils der hinzunehmenden Verlustleistung aus dem integrierten Schaltkreis in die schaltkreisexternen Widerstände $R_v$ und $R_p$ macht es möglich, die Eingabestufe in integrierter Technik mehrkanalig auszuführen. Figur 5 zeigt hierfür ein Beispiel. Auf einem Baugruppenträger 9 ist eine Eingabestufe zur Überwachung von acht Eingangsspannungen realisiert, welche an Klemmen oder Steckverbinder $D_0 - D_7$ angeschlossen sind. Der Baugruppenträger weist weiterhin noch zwei mit $U_B$ und mit Gnd (Masse) bezeichnete Klemmen für die Zuführung der Betriebsspannung auf. Jede Eingangsspannung beaufschlagt eine Konstantstromsenke nach Art der in Figur 3 dargestellten Anordnung, wobei übereinstimmend mit dieser jeweils Parallelwiderstand $R_p$, Vorwiderstand $R_v$ und Statusdiode 5 außerhalb des integrierten Schaltkreises IC auf dem Baugruppenträger 9 angeordnet sind. Die von den einzelnen Schmitt-Triggern gelieferten Signale $S_0 - S_7$ werden schaltkreisintern weiterverarbeitet.

## Patentansprüche

1. Eingabestufe für digitale Signale, insbesondere bei speicherprogrammierbaren Steuerungen, bei der ein Schmitt-Trigger (1) und eine hierzu parallelgeschaltete Zweipolanordnung (ZP) in einem integrierten Schaltkreis (IC) angeordnet sind, **dadurch gekennzeichnet**, daß die Zweipolanordnung (ZP) eine negative Widerstandscharakteristik aufweist und daß der Zweipolanordnung (ZP) ein diese zu einer Konstantstromsenke ergänzender Widerstand ($R_p$) schaltkreisextern parallel zugeordnet ist.

2. Eingabestufe nach Anspruch 1, **dadurch gekennzeichnet**, daß die Zweipolanordnung aus einem Transistor (2) besteht, dessen Steuerelektrode vom Ausgangssignal eines Stromreglers (3) für den Gesamtstrom der Parallelschaltung beaufschlagt ist.

3. Eingabestufe nach Anspruch 1, **dadurch gekennzeichnet**, daß in dem die Zweipolanordnung (ZP) enthaltenden Zweig der Parallelschaltung schaltkreisextern ein Widerstand ($R_v$) eingefügt ist und die Zweipolanordnung aus einem Transistor (2) besteht, dessen Steuerelektrode vom Ausgangssignal eines Stromreglers (7) für den Strom in diesem Zweig beaufschlagt ist.

4. Eingabestufe nach Anspruch 3, **gekennzeichnet** durch eine an den Widerstand ($R_p$) angeschlossene Leuchtdiode (5), der ein von dem Schmitt-Trigger (1) gesteuerter, im integrierten Schaltkreis vorgesehener Schalter (4) parallel zugeordnet ist.

5. Eingabestufe nach Anspruch 3 oder 4, **dadurch gekennzeichnet**, daß sie mehrkanalig ($D_0$-$D_7$) auf einer Baugruppenplatine (9) vorgesehen ist.

## Claims

1. An input stage for digital signals, in particular in programmable controllers, wherein a Schmitt trigger (1) and a two-terminal arrangement (ZP) connected in parallel thereto are arranged in an integrated circuit (IC), characterised in that the two-terminal arrangement (ZP) possesses a negative resistance characteristic and that the two-terminal arrangement (ZP) is assigned in parallel, externally of the circuit, a resistor ($R_p$) by which it is supplemented to form a constant current sink.

4

2. An input stage as claimed in Claim 1, characterised in that the two-terminal arrangement consists of a transistor (2), the control electrode of which is acted upon by the output signal of a current regulator (3) for the overall current of the parallel circuit.

3. An input stage as claimed in Claim 1, characterised in that in the branch of the parallel circuit containing the two-terminal arrangement (ZP) a resistor ($R_v$) is interposed externally of the circuit, and the two-terminal arrangement consists of a transistor (2) whose control electrode is acted upon by the output signal of a current regulator (7) for the current in this branch.

4. An input stage as claimed in Claim 3, characterised by a LED (5) which is connected to the resistor ($R_p$) and to which a switch (4), controlled by the Schmitt trigger (1) and provided in the integrated circuit, is assigned in parallel.

5. An input stage as claimed in Claim 3 or 4, characterised in that it is provided in a multi-channel design ($D_0$-$D_7$) on an assembly carrier (9).

**Revendications**

1. Etage d'entrée pour signaux numériques, notamment dans des commandes programmables par mémoire, dans lequel un Trigger de Schmitt (1) et un montage (ZP) à deux pôles branché en parallèle à celui-ci dans un circuit intégré (IC) sont disposés, caractérisé en ce que le montage (ZP) à deux pôles a une caractéristique de résistance négative et une résistance ($R_p$) complétant un puits de courant constant est disposée à l'extérieur du circuit intégré en parallèle au montage (ZP) à deux pôles.

2. Etage d'entrée suivant la revendication 1, caractérisé en ce que le montage à deux pôles est constitué d'un transistor (2), dont l'électrode de commande reçoit le signal de sortie d'un régulateur (3) de courant pour le courant total du circuit en parallèle.

3. Etage d'entrée suivant la revendication 1, caractérisé en ce qu'une résistance ($R_v$) est insérée à l'extérieur du circuit intégré dans la branche du circuit en parallèle contenant le montage (ZP) à deux pôles et le montage à deux pôles est constitué d'un transistor (2), dont l'électrode de commande reçoit le signal de sortie d'un régulateur (7) de courant pour le courant dans cette branche.

4. Etage d'entrée suivant la revendication 3, caractérisé par une diode électro-luminescente (5) connectée à la résistance ($R_p$), un interrupteur (4) commandé par le Trigger de Schmitt (1) et prévu dans le circuit intégré étant disposé en parallèle à cette diode.

5. Etage d'entrée suivant la revendication 3 ou 4, caractérisé en ce qu'il est prévu avec plusieurs canaux ($D_0$-$D_7$) sur un support (9) pour composants.

FIG 1

FIG 2

FIG 3

FIG 4

FIG 5

EP 0 524 338 B1